Europäisches Patentamt

European Patent Office

Office européen des brevets

(19)

(11) Publication number : **0 482 829 A1**

## (12) EUROPEAN PATENT APPLICATION

(21) Application number : 91309606.1

(22) Date of filing : 17.10.91

(51) Int. Cl.⁵ : **H01L 21/76**

(30) Priority : 26.10.90 US 604844

(43) Date of publication of application :
29.04.92 Bulletin 92/18

(84) Designated Contracting States :
DE FR GB IT

(71) Applicant : **AMERICAN TELEPHONE AND
TELEGRAPH COMPANY**
550 Madison Avenue
New York, NY 10022 (US)

(72) Inventor : **Gregor, Richard William**
427 North 28th Street
Allentown, Pennsylvania 18104 (US)
Inventor : **Leung, Chung Wai**
1501 Red Maple Lane
Allentown, Pennsylvania 18104 (US)
Inventor : **Radosevich, Joseph Rudolph**
3681 Township Line Road
Bethelem, Pennsylvania 18017 (US)
Inventor : **Roy, Pradip Kumar**
2102 Riverbend Road
Allentown, Pennsylvania 18103 (US)

(74) Representative : **Watts, Christopher Malcolm
Kelway et al**
AT&T (UK) LTD. AT&T Intellectual Property
Division 5 Mornington Road
Woodford Green Essex IG8 OTU (GB)

(54) Method for forming a composite oxide over a heavily doped region.

(57) An oxide region (13) is formed over a heavily doped region (15) formed by ion implantation by depositing an oxide layer (11) on a substrate having an oxide-containing surface (3) and heating in an oxidizing atmosphere having a species which moves through the deposited oxide to react with the substrate and form an oxide region (13) between the substrate and deposited oxide layer. The number of defects in the ion implanted, i.e., heavily damaged region, is reduced and the defects do not propagate to regions with good silicon.

*FIG. 3*

EP 0 482 829 A1

## Technical Field

This invention relates to a method for fabricating integrated circuits which includes the step of forming a composite oxide stack over a heavily doped region in the substrate, thereby reducing the number of stress induced dislocations and other defects which may nucleate, propagate, and grow from the heavily doped region to other regions in the substrate.

## Background of the Invention

Essentially all semiconductor integrated circuit processing sequences have one or more steps in which a layer or region of a first material is formed over a layer or region of a second material. A field oxide grown on a silicon substrate and an oxide deposited on a grown oxide are examples of the first and second cases, respectively. Low defect density oxides can be made by the grow-deposit grow process described in *United States Patent 4,851,370 issued on July 25, 1989 to Raymond H. Doklan, Edward P. Martin, Jr., Pradip K. Roy, Scott F. Shive, and Ashok K. Sinha.*

In many cases, at least one of the regions has characteristics which make subsequent processing difficult. An example of interest for this invention is the growth of a thick oxide over a heavily damaged region such as that formed by a high dosage ion implantation process. Such a structure, i.e., a thick oxide over a highly doped region, is used in diverse types of integrated circuits including many EEPROM cells, bipolar transistors with buried layers, and DRAMs with a high *C cell. See, for example, United States Patents 4,750,024 issued on June 7, 1988 to Schreck and 4,853,895 issued on August 1, 1989 to Mitchell et al.* for descriptions of such structures in EEPROM cells. Fabrication of this structure must be done carefully. The oxidation kinetics are changed by the process induced damage and the oxide growth increases the number of defects. Moreover, the number of defects increases as the oxide becomes thicker. While the damaged region may result in growth of a low quality oxide, there is another effect which is even more adverse from the point of view of device quality; i.e., the defects, such as oxidation-induced stacking faults, are likely to propagate into previously undamaged silicon regions during the oxidation process.

Reduction of the defect density is therefore desirable. One technique disclosed in the prior art for reducing the amount of damage caused by the implantation is annealing; that is, a thermal heat treatment which is performed before the oxide is grown. However, the annealing step also drives the dopants further into the substrate, and this effect is frequently undesirable. Other techniques for reducing the process induced damage, such as that caused by ion implantation, would be desirable. Of course, the techniques must satisfy the thermal budget and other process constraints for typical semiconductor integrated circuit processing.

## Summary of the Invention

A method of integrated circuit fabrication comprising the steps of: forming a patterned layer on a substrate which exposes selected portions of said substrate, at least some of said exposed portions of said substrate having a surface comprising an oxide; forming regions having defects in at least part of the exposed portions of said substrate; depositing a layer comprising a material transparent to an oxidizing species, said deposited layer and said oxide having an interface; and forming a grown oxide region underneath said deposited layer and said oxide by heating in an oxidizing atmosphere which has at least one species that can move through said deposited layer and said oxide to the substrate where it reacts with said substrate to form a buried oxide region. It is believed that defects move to the interface between the oxide initially present on the substrate surface and the deposited material. The defects thus do not propagate to other regions in the substrate from the damaged regions. In one embodiment, the regions having defects are doped regions. In a preferred embodiment, the deposited layer comprises an oxide. In a further preferred embodiment, patterned layer comprises an insulator such as a nitride or oxide. In yet another embodiment, the doped regions are formed by ion implantation.

## Brief Description of the Drawing

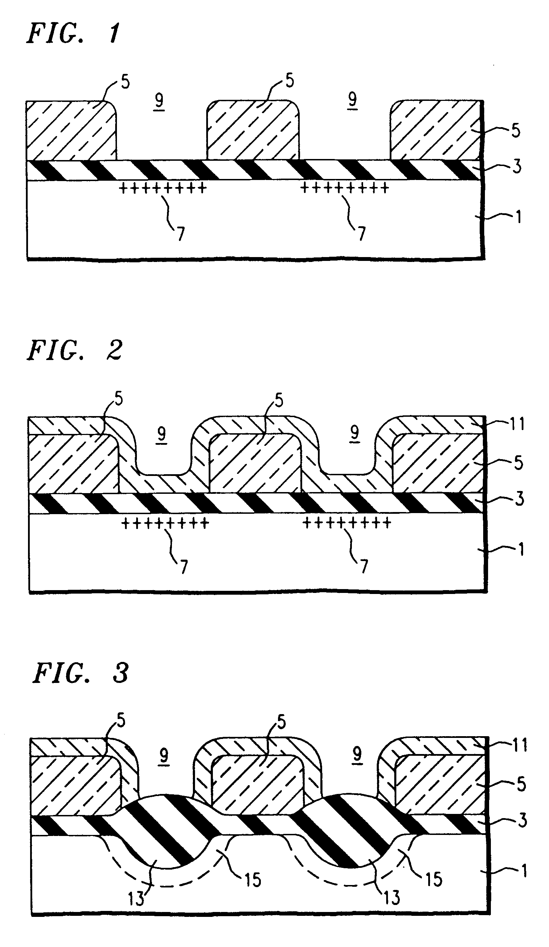

FIGs. 1-3 illustrate steps in the fabrication of devices according to the method of this invention.

## Detailed Description

For reasons of clarity, the elements depicted in the Figures are not drawn to scale. Some elements, which are well known to those skilled in the art, are not depicted as they are not essential to an explanation and understanding of the invention.

A portion of an integrated circuit at an early stage in the manufacturing process according to a preferred embodiment of this invention is shown in sectional view in FIG. 1. Depicted are substrate 1, oxide layer 3, patterned layer 5, and doped regions 7. The oxide layer is typically formed by oxidizing the surface of the substrate, i.e., the substrate has an surface layer comprising an oxide. The term "substrate" is used to mean "an element which supports other elements and thus includes epitaxial layers. " The patterned layer exposes selected portions of the oxide layer 3 through windows 9 in the patterned layer and typically comprises silicon nitride.

This structure is expediently fabricated as follows. A thermal oxide is grown on the substrate surface and the nitride layer is deposited using well-known techniques. Conventional and well-known techniques are then used to pattern the nitride layer and expose the selected portions of the oxide layer through the windows. Those skilled in the art will readily select appropriate dimensions for the elements depicted. For example, the oxide layer is approximately 15nm thick at this point, although the precise thickness is not critical and variations are contemplated. Region 7 is typically formed by ion implantation through oxide layer 3. For example, arsenic ions at an energy of 100 kev may be implanted to yield a dopant concentration of approximately $10^{21}/cm^3$ in region 7. The steps described are well known to those skilled in the art and no further description is required for such persons to practice this invention. As will be readily appreciated by those skilled in the art, the high-dosage ion implantation will render the single crystal silicon amorphous and create defects in the region of the substrate where they are implanted. The doped region is thus a region having defects. As will be appreciated, it is generally considered to be a high defect density region because of the ion implantation.

Variations will be readily apparent to those skilled in the art. The dopant species, dopant concentration, and implantation energy may be varied from the values given. Materials other than nitrides may be used for the patterned layer if they provide a suitable mask for the doping step and do not permit easy diffusion of the oxidizing species used in a later step. For example, portions of the patterned layer may comprise grown field oxides which electrically isolate individual devices of the integrated circuit and may be covered by a nitride layer.

A material, such as an oxide or polysilicon, is now deposited to form layer 11. An exemplary thickness is approximately 20nm. The precise thickness is not critical, as only an interface with layer 3 need be formed. Thick layers are generally undesirable because latter processing will remove both this layer and the patterned layer. The material selected must be transparent to diffusion of an oxidizing species and must form an interface with the grown oxide. It is understood that two oxides can form an interface because they can have different structures even it they have the same nominal composition. Appropriate deposition techniques, such as chemical vapor deposition, will be readily selected by those skilled in the art. For example, a deposited oxide formed by decomposing an oxygen containing precursor can be used. An exemplary oxide is formed by, e.g., the assisted plasma deposition of tetraethylorthosilicate. This oxide is commonly referred to as TEOS. Other deposited oxides, nitrides, etc., may be used. The material is desirably an insulator to facilitate subsequent device fabrication steps. The resulting structure is depicted in FIG. 2.

The structure depicted is heated in an atmosphere having at least one species which can diffuse through the deposited and grown oxide layers to the substrate where it reacts with the substrate to form another, buried oxide region 13. The heating permits the oxidizing species to move through the oxide layers 3 and 11. Those skilled in the art will readily fabricate an oxide with the desired thickness. The thickness depends not only on the oxidation time and temperature, but also on the defect density with higher defect densities yielding greater oxide thicknesses for equal oxidation times and temperatures. A temperature of approximately 900°C is exemplary for the embodiment described. The resulting structure is depicted in FIG. 3. The dopants move during this step and form regions 15. It is hypothesized that these steps reduce the defect density in the substrate caused by the ion implantation step because process induced defects within silicon caused by the ion implantation move to the interface between the grown and deposited oxides where they are trapped. They do not nucleate and propagate to regions of good quality silicon. The grown and deposited layers have defect structures that are misaligned with respect to each other and forms an interface which acts both as a stress sink and defect trap.

The TEOS layer, now densified, and the patterned layer may be stripped and conventional and well-known device processing continued to fabricate, e.g., an EEPROM as well as other types of devices. The oxide regions may serve as platforms for other device elements in the EEPROM. The doped regions 15, which are now buried below the surface, are similar to the source/drain regions in conventional CMOS technology and may be used in similar manners. The elements of an EEPROM are well known to those skilled in the art and need not be described in detail.

Other variations will be readily thought of by those skilled in the art. For example, the regions having defects might be produced by the stress associated with a nitride/oxide oxidation mask.

## Claims

1. A method of integrated circuit fabrication comprising the steps of:

forming a patterned layer(5) on a substrate(1) which exposes selected portions of the substrate(1), at least some of said exposed portions of substrate(1) having a surface comprising an oxide(3);

forming regions(7) having defects in at least part of said exposed portions of the substrate(1), said regions(7) being device regions under said surface;

depositing a layer(11) of a material transparent to an oxidizing species, said material and said oxide(3) forming an interface; and

forming a buried oxide region(13) underneath said oxide(3) by heating in an oxidizing atmosphere which has at least one species which can move through said deposited layer(11) and said oxide(3) to the substrate(1) where it reacts with the substrate(1) to form a buried oxide region(13).

2. A method as recited in claim 1 in which said high defect density regions(7) compromise doped regions.

3. A method as recited in claim 2 in which said forming high-defect density regions(7) step is by ion implantation.

4. A method as recited in claim 1 in which said material(11) transparent to an oxidizing species comprises an oxide.

5. A method as recited in claim 4 in which said depositing is by decomposing an oxygen containing precursor.

6. A method as recited in claim 5 in which said oxygen containing precursor comprises tetraethyloxysilane.

7. A method as recited in claim 1 in which said patterned layer(5) comprises an insulator material.

8. A method as recited in claim 7 in which said insulator material comprises a nitride.

*FIG. 1*

*FIG. 2*

*FIG. 3*

**European Patent Office**

## EUROPEAN SEARCH REPORT

Application Number

EP 91 30 9606

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | EP-A-0197454 (MATSUSHITA)<br>* page 1; figures 2A-2C *<br>* pages 5 - 6 *<br>--- | 1-8 | H01L21/76 |
| Y | EP-A-0012545 (WESTERN ELECTRIC COMP.)<br>* page 5, line 37 - page 6, line 12 *<br>* page 6, line 37 - page 8, line 32; figures 5, 6 *<br>--- | 1-8 | |
| A | US-A-4721687 (M. KAKUMU ET AL)<br>* column 3, line 39 - column 4, line 28; figures 2A-2F *<br>--- | 1 | |
| D,A | US-A-4750024 (J. F. SCHRECK)<br>* column 4, lines 23 - 57; figures 5-8 *<br>--- | 1-3, 6-8 | |
| D,A | US-A-4851370 (R. H. DOKLAN ET AL)<br>* column 3, line 58 - column 4, line 32; figure 1 *<br>----- | 1 | |

TECHNICAL FIELDS SEARCHED (Int. Cl.5 )

H01L

The present search report has been drawn up for all claims

| Place of search | Date of completion of the search | Examiner |
|---|---|---|
| BERLIN | 07 JANUARY 1992 | ROUSSEL A.T. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................................
& : member of the same patent family, corresponding document

EPO FORM 1503 03.82 (P0401)